# EUROPÄISCHE PATENTSCHRIFT

(11) **EP 1 509 838 B1**
(45) Veröffentlichungstag und Bekanntmachung des Hinweises auf die Patenterteilung: **15.03.2006**
(21) Anmeldenummer: 03727482.6
(22) Anmeldetag: 15.05.2003
(51) Int. Cl.: G06F 7/58

(54) **ZUFALLSSIGNALGENERATOR**
RANDOM SIGNAL GENERATOR
GENERATEUR DE SIGNAUX ALEATOIRES

(30) Priorität: 22.05.2002 DE 10223252
(43) Veröffentlichungstag der Anmeldung: 02.03.2005
(73) Patentinhaber: Bergmann, Frank, D-15537 Grünheide (DE)
(72) Erfinder: Bergmann, Frank, D-15537 Grünheide (DE)
(74) Vertreter: Eisenführ, Speiser & Partner
(86) Internationale Anmeldenummer: PCT/EP2003/005133
(87) Internationale Veröffentlichungsnummer: WO 2003/098428

(56) Entgegenhaltungen:
- EP-A- 0 981 081
- EP-A- 1 197 846
- US-A- 4 395 703
- US-A- 5 627 775
- US-A- 6 070 178

## Beschreibung

Die Erfindung betrifft einen Zufallssignalgenerator, der insbesondere zur Generierung von Zufallszahlen Verwendung finden kann.

Die Erzeugung von Zufallssignalen hat auf vielen Gebieten der Technik und Wissenschaft große Bedeutung. So basieren, beispielsweise kryptographische Verfahren zumeist auf derartigen Zufallssignalen, die mit geeigneten mathematischen Algorithmen Pseudozufallszahlen erzeugen. Streng genommen sind diese Pseudozufallszahlen nicht zufällig, denn mit Kenntnis des erzeugenden Algorithmus ist jede Person in der Lage immer genau die gleiche Folge von Zufallszahlen zu reproduzieren, bzw. die nachfolgenden Zufallszahlen vorauszusagen. Es ist daher von eminenter Bedeutung eine manipulationssichere Quelle für zugrundeliegende Zufallssignale zu besitzen, deren zufällige Bits in Algorithmenimplementationen gesammelt werden können.

Theoretisch denkbar sind zunächst manuelle Entropiequellen, in denen ein Benutzer durch Experimente zufällige Ergebnisse erzeugt, so beispielsweise durch Münzwurf oder Würfeln. Experimente dieser Art liefern allerdings nur wenig Entropie und sind für Echtzeitanwendungen nicht geeignet, da die Ausführung zu lange dauert.

Es ist ferner bekannt, zufällige Ereignisse im Computersystemen als Entropiequelle zu nutzen. Zu solchen Quellen zählen beispielsweise Netzwerkzugriffe, Rauschen auf A/D-Wandlern durch Außengeräusche oder Luftwirbel im Beriech von Festplatten, die die Bewegung der Schreib-Lese-Köpfe der Festplatte verzögern und ein chaotisches System bilden, über das keine Vorhersage möglich ist. Denkbar ist auch Mausbewegungen und Tastaturanschläge zu erfassen. Diese halbautomatischen bzw. automatischen Quellen sind zwar relativ kostengünstig, jedoch sind auch sie für Echtzeitanwendungen, in denen pro Sekunde mehrere Bit Entropie benötigt werden, ungeeignet.

Als weitere Entropiequelle kommen physikalische Effekte in Frage, die entweder echt zufällig sind oder zumindest in einem so chaotischen System auftreten, dass sie nicht vorhersagbar sind.

In diesem Zusammenhang wurden beispielsweise Zufallszahlengeneratoren entwickelt, denen als Zufallssignalquelle ein nuklearer Zerfall radioaktiver Elemente zugrunde liegt Allerdings erfordern die verwendeten Materialien eine Abschirmung und sind inhärent gesundheitsschädlich.

Ein alternativer Ansatz sieht vor, das atmosphärische Rauschen in einem Funkempfänger als Entropiequelle zu nutzen. Die Quelle muss allerdings geheim gehalten werden, da sonst ein passiver Angreifer Aussagen über die erhaltenen Zufallszahlen machen könnte und ggf. sogar ein pseudozufälliges Rauschen seiner Wahl erzeugen könnte.

Eine weitere Quelle für Zufallssignale ist das thermische Rauschen elektronischer Bauelemente, wie beispielsweise von Halbleiterdioden. Bekannte Lösungen für physikalische Zufallsgeneratoren sind allerdings bauelementeaufwendig und erfordern Spezialkenntnisse. So müssen im allgemeinen Parameter vorgegebenen werden, die die Art und Weise der Rauschsignalerzeugung und Verstärkung bestimmen. Gerade bei der Integration in kryptographische Systeme werden Kompromisse auf Kosten der statistischen Qualität durch Selektion von Bauelementen mit speziellen Rauscheigenschaften oder kritischer Abgleichparameter zur Einstellung eines Gleichanteils der 0/1-Bits notwendig. Die empfindlichen Abgleichparameter sind temperatur- und spannungsabhängig und verändern sich durch Alterung der Bauelemente. Die resultierende statistische Qualität der Zufallszahlen ist in der Folge nicht deterministisch auf durchschnittlichem Niveau und damit für hohe Sicherheitsaufwendungen, zum Beispiel Schlüssetgenerierung in kryptographischen Systemen nicht akzeptabel. Ungenügende Qualität wird oftmals durch Verknüpfung mit Pseudozufallszahlen oder Kryptoalgorithmen kaschiert, ohne die negativen Folgen für den Einsatz in kryptographischen Systemen zu erläutern. Auch der Materialaufwand und Bauraumbedarf bekannter physikalischer Zufallszahlengeneratoren lässt derzeit keine kostengünstige Integration in Applikationen zu bzw. erfordert den Einsatz eines PC.

Aus der DE 199 10 729 C1 ist ein System bekannt, bei dem zwei Zufallszahlengeneratoren über ein Exklusiv-ODER-Gatter Zufallszahlen erzeugen. Die zugrunde liegenden Zufallssignalquellen sind wieder konventioneller Natur, d.h. greifen auf eine Rauschspannung einer Halbleiterdiode zurück ohne jedoch temperatur- und spannungsabhängige Signaleinflüsse zu berücksichtigen.

US 6,070,178 beschreibt einen Zufallssignalgenerator, der die Differenz zweier Rauschsignale von Zener-Dioden oder anderen Rauschquellen verstärkt und anschlie-ßend digitalisiert, so dass auf diese Weise ein digitales Zufallssignal bereitgestellt wird. Die statistische Qualität des erzeugten Zufallssignals ist jedoch niedrig und zahlreichen Störeinflüssen unterworfen.

US 4,395,703 beschreibt einen Zufallssignalgenerator, der ein unipolares Rauschsignal aus einer beliebigen Quelle einem Differenzverstärker zuführt, dessen Ausgangssignal von einem Flip-Flop als 1-bittige A/D-Wandierschaltung abgetastet wird. Das Rauschsignal wird dabei kapazitiv auf den den nichtinvertierenden Eingang des Differenzverstärkers eingekoppelt, dessen Arbeitspunkt über eine Mittelung einer alternierenden Folge logischer Nullen und Einsen eingestellt wird. Auf den invertierenden Eingang des Differenzverstärkers wird zur Erhöhung der statistischen Qualität des digitalen Zufallssignals dieses in gleicher Weise wie für den Arbeitspunkt des nichtinvertierenden Eingangs gemittelt und auf den invertierenden Eingang zurückgekoppelt. Die statistische Qualität des erzeugten Zufallssignals ist aufgrund der unipolaren Verarbeitung des Rauschsignals und der dadurch gegebenen hohen Anfälligkeit für Störeinflüsse herabgesetzt.

Dem erfindungsgemäßen Zufallssignalgenerator liegt daher die Aufgabe zugrunde, die Limitierungen des Standes der Technik zu überwinden und in kostengünstiger Weise eine einfache und stabile Generierung von Zufallssignalen in konstanter hoher statisticher Qualität zu ermöglichen.

Diese Aufgabe wird durch den Zufallssignalgenerator mit den im Anspruch 1 genannten Merkmalen gelöst. Dazu umfasst der Zufallssignalgenerator
(a) zwei Z-Dioden als thermische Rauschquellen, die ausgangsseitig je ein Rauschsignal bereitstellen,
(b) einem eingangsseitig mit den beiden Z-Dioden verbundenen Differenzverstärker, der periodische Störsignale unterdrückt, ausgangsseitig ein Differenz-Rauschsignal bereitstellt und eine Arbeitspunktstabilisierung durch Signalrückkopplung ermöglicht und
(c) einer A/D-Wandlerschaltung, auf die eingangsseitig das Differenz-Rauschsignal geschaltet ist, die ausgangsseitig ein digitales Zufallssignal aus aufeinanderfolgenden Zufallsbits bereitstellt und eine Arbeitspunktstabilisierung durch Signalrückkopplung ermöglicht.

Mit der Erfindung wird eine kostengünstige, einfache und stabile Generierung von Zufallszahlen mit konstanter hoher statistischer Qualität erreicht. Durch die geringe Anzahl von Standardbauelementen ist eine Implementierung auch in kleinen und mobilen Systemen möglich. Die Art und Weise der Rauschsignalerzeugung und Verstärkung kompensiert weitestgehend Störsignale.
Sowohl Differenzverstärker als auch A/D-Wandlerschaltung umfassen eine Signalrückkopplungsschaltung, die einen Arbeitspunkt des Differenzverstärkers bzw. der A/D-Wandlerschaltung bestimmt. Hierdurch kann ein Abgleich aller Parameter von Verstärkung und Digitalisierung automatisch erfolgen, so dass physikalische Zufallszahlengeneratoren basierend auf dem erfindungsgemäßen Zufallssignalgenerator ohne Spezialkenntnisse industriell gefertigt werden können. In einer besonders einfachen Variante ist die Signalrückkopplungsschaltung ein Tiefpass.

In einer bevorzugten Ausgestaltung der Erfindung läuft das digitale Zufalissignal eingangsseitig an einer digitalen Nachbearbeitungsschaltung auf. Die Nachbearbeitungsschaltung umfasst einen Mikrocontroller mit einer Exklusiv-Oder-Verknüpfung von aufeinanderfolgenden Zufallsbits. Hierdurch kann die Entropie der generierten Zufallsbits weiter erhöht werden.

Die Exklusiv-Oder- Verknüpfung ist vorzugsweise derart ausgelegt, dass 2-16, insbesondere drei, aufeinanderfolgende Zufallszahlen miteinander verknüpft sind. Die Zahl der in dem genannten Größenbereich verknüpften Zufallszahlen lässt sich bauelementetechnisch noch durch vertretbaren Aufwand realisieren und es kann auf bestehende Lösungen zurückgegriffen werden.

Eine Abtastrate des an der Nachbearbeitungsschaltung auflaufenden Zufaflssignals liegt vorzugsweise im Bereich von 1/8 bis 1/12, insbesondere 1/10, einer mittleren Frequenz des Zufallssignals. Ferner dient der Mikrocontroller vorzugsweise einer Synchronisation der Datenausgabe des Zufallssignals in einem Bereich von 10-100 Kbit/s, insbesondere von 40-60 Kbit/s. Die genannten Bereiche bzw. Abtastraten haben sich in statistischen Tests als zuverlässig erwiesen und sind in der Praxis einfach realisierbar.

Ferner ist bevorzugt, dass die A/D-Wandlerschaltung ein Schmitt-Trigger ist, da er wenig Raumbedarf hat und sich bei statistischen Test als besonders zuverlässig erwiesen hat. Der Schmitt-Trigger kann selbst negierend ausgelegt sein oder ihm wird ein Negator nachgeschaltet.

Besonders bevorzugt ist ferner ein erfindungsgemäße Ausführung des Zufallssignalgenerators, bei der die Z-Dioden einen Arbeitsbereich von 9 bis 11 V, insbesondere von 9,5 bis 10,5 V, besitzen. In der Praxis hat sich dieser Bereich als besonders zuverlässig für die Erzeugung von Zufallsbits erwiesen.

Weiter bevorzugte Ausgestaltungen der Erfindung ergeben sich aus den übrigen, in den Unteransprüchen genannten Merkmalen.

Die Erfindung wird nachfolgend in einem Ausführungsbeispiel und anhand von Zeichnungen näher erläutert. Es zeigen:
- Fig. 1: ein Blockschaltbild eines physikalischen Zufallssignalsgenerators in einer Prinzipanordnung,
- Fig. 2: einen Schaltplan eines konkreten Zufallssignalgenerators,
- Fig. 3a und 3b: Signalverläufe an einem Differenzverstärker bzw. einer A/D-Wandlerschaltung nachgeordneten Messpunkten.

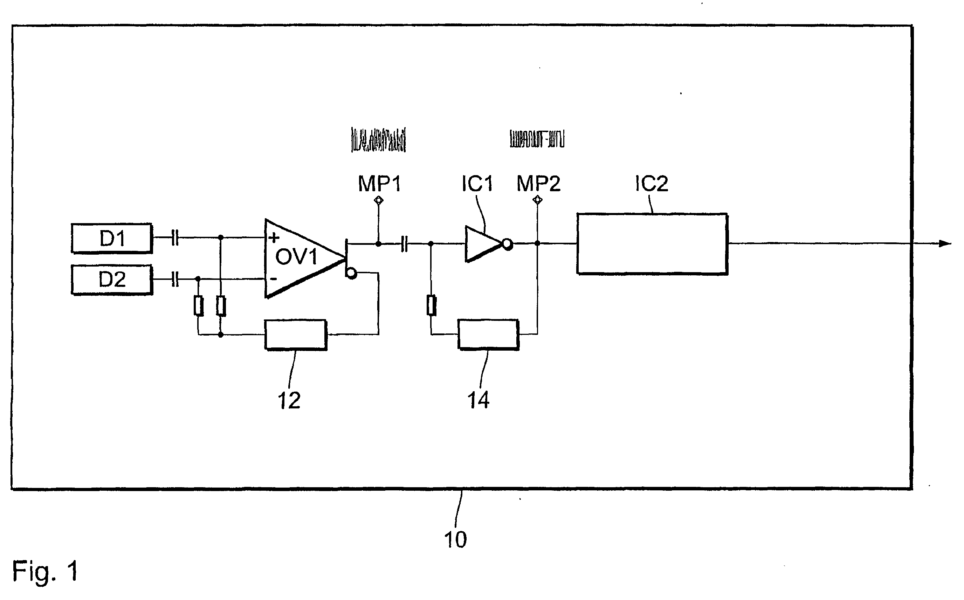

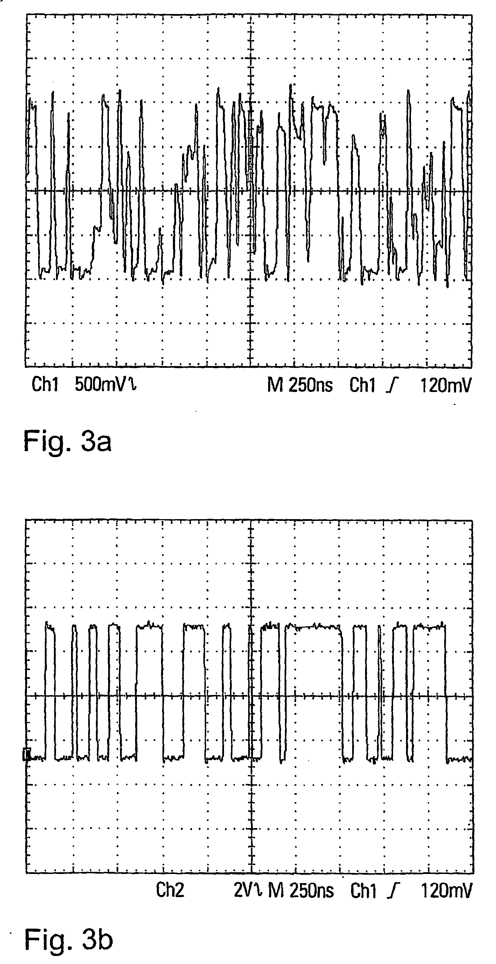

Die Fig. 1 zeigt eine prinzipielle Anordnung der einzelnen Bauelemente eines Zufallssignalgenerators 10, der als Hardwarekomponente Bestandteil eines auf Pseudozufallszahlen basierenden kryptographischen Systems sein kann.
Der Zufallssignalgenerator 10 beinhaltet als entropische Rauschquellen zwei Halbleiterdioden - hier in Form zweier 10 V-Z-Dioden D1 und D2. Die beiden Z-Dioden D1, D2 haben Arbeitspunkte, die im Knickbereich der U/I-Kennlinie liegen und liefern je ein Rauschsignal, Die Rauschsignale sind eingangsseitig an einen Differenzverstärker OV1 mit hoher Gleichtaktunterdrückung geschaltet, der ausgangsseitig ein verstärktes Differenzrauschsignal der beiden Z-Dioden D1, D2 bereitstellt. Durch den Einsatz des Differenzverstärkers OV1 werden periodische Störungen, wie Schwankungen der Versorgungsspannung der Z-Dioden D1, D2 weitgehend unterdrückt. Der invertierende Ausgang des Differenzverstärkers OV1 wird über ein Tiefpass an dessen Eingänge rückgekoppelt und bestimmt somit den Arbeitspunkt der beiden Differenzeingänge (Signalrückkopplungsschaltung 12). Eine mittlere Rauschfrequenz am Messpunkt MP1 des nichtinvertierenden Differenzverstärkers OV1 beträgt beispielsweise ca. 15 MHz. Das Differenzrauschsignal ist oberhalb des Messpunktes MP1 angedeutet und noch einmal vergrößert in der Fig. 3a wiedergegeben.
Zur Digitalisierung des Differenzrauschsignals wird der nichtinvertierende Ausgang des Differenzverstärkers OV1 galvanisch entkoppelt und an einen Eingang einer nachfolgenden, invertierenden A/D-Wandlerschaltung IC1 - hier in Form eines Schmitt-Triggers - geschaltet. Zur Arbeitspunkteinstellung des Schmitt-Triggers wird das am Ausgang auflaufende digitale Zufallssignal über einen Tiefpass an den Eingang rückgekoppelt (Signalrückkopplungsschaltung 14). Durch diese Maßnahme wird ein Gleichspannungsanteil des digitalisierten Zufallssignals immer auf ½ der Versorgungsspannung geregelt. Dadurch schwankt der statistische Anteil der logischen 0/1-Zufallsbits immer nah einer idealen 1:1-Verteilung. Das resultierende digitale Zufallssignal ist zur Veranschaulichung an einem Messpunkt MP2 oberhalb der Schaltung dargestellt und noch einmal vergrößert der Fig. 3b zu entnehmen.
Um die Entropie der mit dem digitalen Zufallssignal erzeugten Zufallsbits weiter zu erhöhen, erfolgt eine mathematische Nachbehandlung des digitalen Zufallssignals. Dazu wird das Signal zunächst in eine digitale Nachbearbeitungsschaltung IC2 eingespeist. Die Nachbearbeitungsschaltung IC2 fasst einen Mikrocontroller mit einer Exklusiv-Oder-Verknüpfung von aufeinanderfolgenden Zufallsbits. Einzelne Elemente eines derartigen Mikrocontrollers können hardwaremäßig, aber auch durch geeignete Software bereit gestellt werden. Solche Mikrocontroller sind aus dem Stand der Technik hinlänglich bekannt, so dass sich ein weiteres Eingehen hierauf erübrigt.

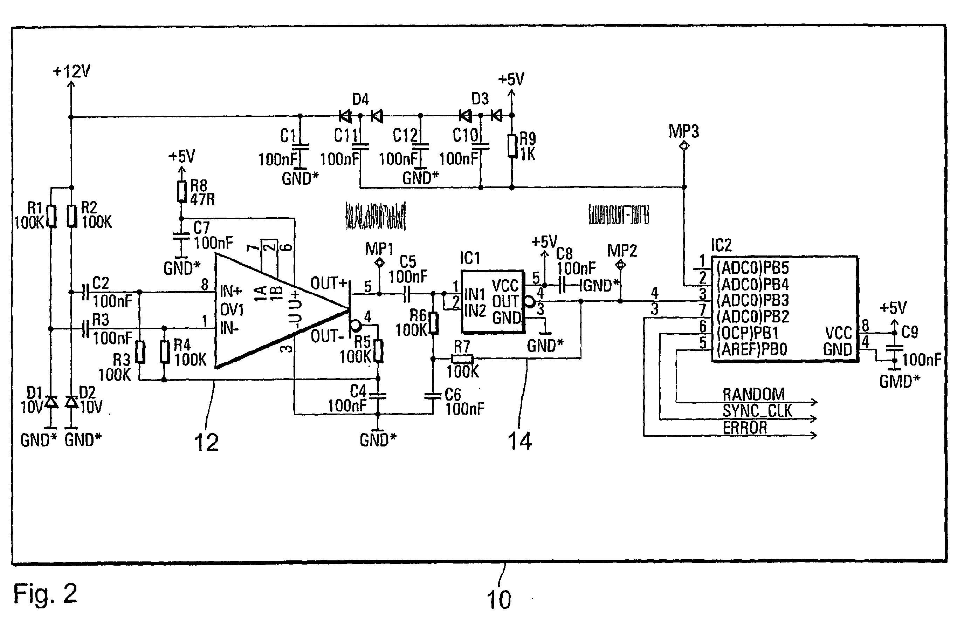

Der Fig. 2 ist der konkrete Schaltplan eines Zufallssignalgenerators 10, wie er vorhergehend beschrieben wurde, zu entnehmen. Eine Dimensionierung der Schaltung ist unkritisch und arbeitet bei einer Versorgungsspannung von 4,5 bis 5,5 V, wobei eine Toleranz der Werte der Bauelemente mehr als 10 % vom Sollwert betragen kann.
Die Bereitstellung der 12V-Versorgungsspannung für die als Rauschquellen fungierenden 10V-Z-Dioden D1, D2 erfolgt aus einer Spannungsvervielfachung. Dazu generiert ein Mikrocontroller einen symmetrischen Takt von ca. 30 KHz. Über die Dioden D3 und D4 sowie die Kondensatoren C10, C11 und C12 wird durch eine Spannungsvervielfachung die 5V-Versorgungsspannung auf ca. 12,5V erhöht. Die Toleranz der 12V-Spannung kann bis zu 1V betragen und wird am Kondensator C 1, in der Nähe von den Widerständen R1 und R2 abgeblockt. Der Strom durch die 10V-Z-Dioden D1, D2 ist durch die Widerstande R1, R2 von jeweils 100KΩ auf ca. 20pA je Z-Diode begrenzt.

Die breitbandigen Rauschsignale mit Spitzenspannungen von ca. 5mVss werden galvanisch an den Kondensatoren C2, C3 entkoppelt und an die Eingänge des Differenzverstärkers OV1 geschaltet. Es wird ein Videoverstärker mit einer Verstärkung von 400 bei 90MHz Bandbreite eingesetzt. Durch eine hohe Gleichtaktunterdrückung (>50dB) werden Gleichtakte - Störungen auf der Stromversorgung mit Auswirkung auf die statistische Qualität - wirkungsvoll eliminiert.
Der invertierende Ausgang wird über einen Tiefpass (*T*=10ms; Widerstand R5; Kondensator C4) geleitet und hochohmig zur Arbeitspunkteinstellung der Differenzeingange des Videoverstärkers benutzt (Signalrückkopplungsschaltung 12). Dadurch entsteht am nichtinvertierenden Ausgang immer ein um die halbe Versorgungsspannung symmetrisch ausgesteuertes, breitbandiges analoges Differenz-Rauschsignal mit einer mittleren Frequenz von 15MHz und einer Ausgangsamplitude von 2Vss (siehe Fig. 3a).

Dieses Differenz-Rauschsignal wird am Kondensator C5 galvanisch entkoppelt und an einen negierenden Schmitt-Trigger-Logikschaltkreis (A/D-Wandlerschaltung IC1) geschaltet. Auch hier wird das Ausgangssignal über einen Tiefpass (*T*=10ms; Widerstand R7, Kondensator C6) zur Arbeitspunkteinstellung für den Triggerpunkt rückgekoppelt (am Widerstand R6). Durch die relativ große Hysteresis des Schmitt-Triggers von ca. 1V reduziert sich das digitalisierte Rauschsignal auf eine mittlere Frequenz von ca. 6MHz. Die automatische Arbeitspunkteinstellung bleibt auch bei Spannungs- und Temperaturänderungen (4,5 bis 5,5V; -20°C bis 85°C) stabil und garantiert ein symmetrisches Verhältnis von 0/1-Bits am Ausgang des Schmitt-Triggers (siehe Fig. 3b). Die Stromaufnahme beträgt bei 5,0V ca. 15 mA.

Zur Erhöhung der Entropie der generierten Zufallsbits erfolgt eine Exclusiv-ODER-Verknüpfung von drei aufeinanderfolgenden Zufatlsbits in einem Mikrocontroller. Die Abtastrate des Zufallssignals ist auf ca. 1/10 der mittleren Frequenz des digitalisierten Zufallssignals eingestellt. Weitere Aufgaben des Mikrocontrollers sind die Überwachung der statistisch gleichverteilten Zufallsbits und eine synchrone Datenausgabe des digitalen Zufallssignals von ca. 50 Kbit/s. Es ist sinnvoll, ausschließlich SMD-Bauelemente einzusetzen. Die Anordnung der Bauelemente ist unkritisch, sofern für kurze Signalwege gesorgt wird. Unmittelbar in der Nähe des Differenzverstärkers OV1, der A/D-Wandlerschaltung IC1 und der digitalen Nachbearbeitungsschaltung IC2 werden Abblockkondensatoren C7, C8 und C9 plaziert. Für das Bezugspotential GND und die Versorgungsspannung +5V sind Polygonflächen zu generieren. Bei dieser Applikation haben Musterplatinen die Abmessungen von 20 x 25 mm und sind zweiseitig entflechtet.

Die erreichte statistische Qualität nach einer Exclusiv-ODER-3-Verknüpfung verdeutlicht eine statistische Analyse. Der in der nachfolgend aufgeführte statistische Test ist für Anforderungen an einen idealen Zufallszahlengenerator entwickelt worden und wird durch die beschriebene Applikation reproduzierbar erfüllt.

### Statistischer Test für Bitfolgen

### Größe der Bitfolge: 10.000.000 Bytes (XOR3)

Test der Null-Hypothese: Vorliegende Bitfolge ist eine Folge unabhängig ausgeloster Zahlen 0,1 mit gleicher Wahrscheinlichkeit p = 0,5.

Byte-Zählung nicht überlappend:

| | | | | | | | | |
|---|---|---|---|---|---|---|---|---|
| 00 | 39101 | 39251 | 39208 | 39253 | 39214 | 38565 | 39025 | 39287 |
| 08 | 38901 | 39059 | 39394 | 38708 | 39204 | 39173 | 39097 | 38729 |
| 10 | 38571 | 38897 | 39272 | 39004 | 39104 | 38731 | 39397 | 39215 |
| 18 | 39380 | 38940 | 38898 | 38872 | 39152 | 39344 | 39019 | 38971 |
| 20 | 39008 | 39455 | 39215 | 38800 | 38889 | 39154 | 39264 | 38957 |
| 28 | 38958 | 38860 | 39389 | 38978 | 38758 | 39125 | 38793 | 39187 |

| | | | | | | | | |
|---|---|---|---|---|---|---|---|---|
| 30 | 39291 | 38700 | 39188 | 39260 | 39061 | 38732 | 39308 | 39233 |
| 38 | 38836 | 39160 | 39219 | 39018 | 38947 | 39119 | 39231 | 38975 |
| 40 | 39161 | 39214 | 39140 | 39202 | 38731 | 39498 | 38745 | 39093 |
| 48 | 39155 | 38955 | 39188 | 39255 | 39191 | 39197 | 39219 | 39099 |
| 50 | 39314 | 38978 | 39147 | 39539 | 39137 | 39463 | 39052 | 39152 |
| 58 | 38770 | 38935 | 38971 | 38644 | 38600 | 39129 | 39159 | 39077 |
| 60 | 38922 | 39512 | 38838 | 39131 | 39329 | 39081 | 39092 | 39086 |
| 68 | 39150 | 39147 | 38777 | 38768 | 39238 | 39052 | 38612 | 38851 |
| 70 | 38799 | 38895 | 38874 | 39356 | 39042 | 38868 | 39284 | 39360 |
| 78 | 39148 | 38684 | 38856 | 39146 | 39298 | 38873 | 39119 | 38900 |
| 80 | 39015 | 38908 | 38997 | 38980 | 39375 | 38796 | 38977 | 39148 |
| 88 | 39140 | 39453 | 39233 | 39062 | 38916 | 39106 | 39308 | 38860 |
| 90 | 39125 | 39176 | 39220 | 39153 | 38749 | 38914 | 38997 | 38646 |
| 98 | 39115 | 39013 | 38939 | 38822 | 39203 | 39004 | 39075 | 39351 |
| a0 | 39076 | 39124 | 39068 | 39027 | 39131 | 39129 | 38950 | 39267 |
| a8 | 38522 | 38997 | 38810 | 39144 | 39086 | 38938 | 38846 | 39398 |
| b0 | 38995 | 39290 | 38772 | 39103 | 39240 | 39202 | 39133 | 38921 |
| b8 | 39037 | 38977 | 39070 | 38958 | 38796 | 39101 | 39215 | 39129 |
| c0 | 39174 | 38835 | 38749 | 39068 | 39410 | 39410 | 39270 | 39200 |
| c8 | 39159 | 39079 | 39009 | 39029 | 39036 | 39184 | 39063 | 39078 |
| d0 | 39325 | 38945 | 38854 | 38892 | 39188 | 39454 | 38991 | 38887 |
| d8 | 39005 | 39154 | 39008 | 39132 | 38873 | 39092 | 39137 | 39243 |
| e0 | 39214 | 38993 | 39353 | 39285 | 39256 | 39148 | 38875 | 39026 |
| e8 | 39137 | 39082 | 39146 | 38741 | 38717 | 38876 | 38723 | 39074 |
| f0 | 38997 | 39057 | 39238 | 38963 | 38901 | 38929 | 39211 | 39315 |
| f8 | 39087 | 38879 | 38698 | 39096 | 38782 | 39434 | 39250 | 39154 |

Auswertung der Zählung von 10.000.000 Bytes = 80.000.000 Bits:
Theoretischer Mittelwert der Byte-Häufigkeiten: 39062
Minimum: 'a8' = 38522 Maximum: '53' = 39539

Theoretisches Intervall I für die Byte-Häufigkeiten:
I = (38676 bis 39449) (für 95 % der 256 Häufigkeiten)

### Prüfkriterium 1:

Die theoretisch zulässige Anzahl der 5% Ausreißer (Mittelwert 13) aus dem Intervall I liegt mit 95%-iger Sicherheit zwischen 6 und 20.

Tatsächliche Anzahl der Ausreißer aus dem Intervall I:

| | | |
|---|---|---|
| unten: 7 | oben: 7 | insgesamt: 14 |

### Prüfkriterium 2:

### Untersuchung von Byte-Häufigkeiten:

Prüfgröße = χ² = Summe der quadrierten Abweichungen der Häufigkeiten vom Mittelwert der Häufigkeiten, dividiert durch den Mittelwert.

### Byte-Häufigkeiten nicht überlappend:

Testgröße: χ² für 8-Bit-Muster.
Theoretischer maximaler χ²-Wert = 293,25 (mit einer Sicherheit von 95%)
Berechneter χ²-Wert = 262,07

Byte-Häufigkeiten überlappend:
Testgröße: χ²-Wert für 8-Bit-Muster minus χ²-Wert für 7-Bit-Muster.
Theoretischer maximaler χ²-Wert = 155,40 (mit einer Sicherheit von 95%)
Berechneter χ²-Wert = 125,17

### Prüfkriterium 3:

### relative Häufigkeit von Bit 1 in der Folge R = 0,49996465

Aus der Null-Hypothese folgt: R wird außerhalb des zu 0,5 symmetrischen offenen Intervalls (0,49996465 , 0,50003535), das R als eine Grenze hat, mit einer Wahrscheinlichkeit von w = 0,52720356 beobachtet.

### Prüfkriterium 4:

Häufigkeiten sich überlappender Bit-Bigramme:

| | | | |
|---|---|---|---|
| Bigramm 00: | 20005470 | Bigramm 01: | 19997358 |
| Bigramm 10: | 19997358 | Bigramm 11: | 19999814 |

Testgröße: χ²-Wert für 2-Bit-Muster minus χ²-Wert für die Einzel-Bits
Theoretischer maximaler χ²-Wert = 5,99 (mit einer Sicherheit von 95%)
Berechneter χ²-Wert = 1,80

### Prüfkriterium 5:

Häufigkeiten der Bit-Bigramme an geraden Stellen:

| | | | |
|---|---|---|---|
| Bigramm 00: | 10002852 | Bigramm 01: | 10002334 |
| Bigramm 10: | 9994790 | Bigramm 11: | 10000024 |

Theoretischer maximaler χ²-Wert = 7,81 (mit einer Sicherheit von 95%)
Berechneter χ²-Wert = 4,07

### Prüfkriterium 6:

Häufigkeiten der Bit-Bigramme an ungeraden Stellen:

| | | | |
|---|---|---|---|
| Bigramm 00: | 10002618 | Bigramm 01: | 9995024 |
| Bigramm 10: | 10002568 | Bigramm 11: | 9999790 |

Theoretischer maximaler χ²-Wert = 7,81 (mit einer Sicherheit von 95%)
Berechneter χ²-Wert 3,83

### Ergebnis der Untersuchung:

Die Prüfkriterien Nr. 1, 2, 3, 4, 5, 6 sind erfüllt. Die Folge hat den statistischen Test bestanden. Die Null-Hypothese wird angenommen.

## Patentansprüche

1. Zufallssignalgenerator (19) mit
(a) zwei Z-Dioden (D1, D2) als thermische Rauschquellen, die ausgangsseitig je ein Rauschsignal bereitstellen,
(b) einem eingangsseitig mit den beiden Z-Dioden (D1, D2) verbundenen Differenzverstärker (OV1), der periodische Störsignale unterdrückt,
(c) einer A/D-Wandlerschaltung (IC1), auf die eingangsseitig das Differenz-Rauschsignal geschaltet ist, die ausgangsseitig ein digitales Zufallssignal aus aufeinanderfolgenden Zufallsbits bereitstellt,
**dadurch gekennzeichnet, daß**
(d) der Differenzverstärker durch Signalrückkopplung des DifferenzRauschsignals auf beide Eingänge des Differenzverstärkers eine Arbeitspunktstabilisierung ermöglicht und
(e) die A/D-Wandlerschaltung durch Signalrückkopplung des digitalen Zufallssignals auf den Eingang der A/D-Wandlerschaltung eine Arbeitspunktstabilisierung ermöglicht.

2. Zufallssignalgenerator nach Anspruch 1, **dadurch gekennzeichnet, dass** das digitale Zufallssignal eingangsseitig an einer digitalen Nachbearbeitungsschaltung (IC2) aufläuft, die einen Mikrocontroller mit einer Exclusiv-ODER-Verknüpfung von aufeinanderfolgenden Zufallsbits umfasst.

3. Zufallssignalgenerator nach Anspruch 2, **dadurch gekennzeichnet, dass** das Exclusiv-ODER-Gatter derart ausgelegt ist, dass 3 aufeinanderfolgende Zufallsbits verknüpft sind.

4. Zufallssignalgenerator nach Anspruch 2, **dadurch gekennzeichnet, dass** die digitale Nachbearbeitungsschaltung (IC2) derart ausgelegt ist, dass eine Abtastrate des auflaufenden Zufallssignals auf 1/8 bis 1/12, insbesondere 1/10, einer mittleren Frequenz des Zufallssignals eingestellt ist.

5. Zufallssignalgenerator nach einem oder mehreren der Ansprüche 1 bis 4, **dadurch gekennzeichnet, dass** die Signalrückkopplungsschaltung (12, 14) zur Arbeitspunktstabilisierung ein Tiefpass ist.

6. Zufallssignalgenerator nach einem oder mehreren der Ansprüche 1 bis 5, **dadurch gekennzeichnet, dass** die A/D-Wandlerschaltung (IC1) ein negierender Schmitt-Trigger-Logikschaltkreis oder ein Schmitt-Trigger-Logikschaltkreis mit nachgeschaltetem Negator ist.

7. Zufallssignalgenerator nach einem oder mehreren der Ansprüche 1 bis 6, **dadurch gekennzeichnet, dass** die Z-Dioden einen Arbeitsbereich von 9 bis 11 V besitzen.

8. Zufallssignalgenerator nach Anspruch 7, **dadurch gekennzeichnet, dass** die Z-Dioden einen Arbeitsbereich von 9,5 bis 10,5 V besitzen.

## Claims

1. A random signal generator (19) comprising
(a) two Z-diodes (D1, D2) as thermal noise sources which each provide a respective noise signal at the output side,
(b) a differential amplifier (OV1) which is connected at the input side to the two Z-diodes (D1, D2) and which suppresses periodic interference signals, and
(c) an A/D converter circuit (IC1) to which the differential noise signal is applied at the input side and which at the output side provides a digital random signal comprising sequential random bits,
**characterised in that**
(d) the differential amplifier permits operating point stabilisation by signal feedback of the differential noise signal to both inputs of the differential amplifier and
(e) the A/D converter circuit permits operating point stabilisation by signal feedback of the digital random signal to the input of the A/D converter circuit.

2. A random signal generator according to claim 1 **characterised in that** the digital random signal passes at the input side to a digital post-processing circuit (IC2) which includes a microcontroller with an exclusive-OR linking of sequential random bits.

3. A random signal generator according to claim 2 **characterised in that** the exclusive-OR gate is so designed that 3 sequential random bits are linked.

4. A random signal generator according to claim 2 **characterised in that** the digital post-processing circuit (IC2) is so designed that a sampling rate of the arriving random signal is set to 1/8 to 1/12 and in particular 1/10 of a mean frequency of the random signal.

5. A random signal generator according to one or more of claims 1 to 4 **characterised in that** the signal feedback circuit (12, 14) for operating point stabilisation is a low pass means.

6. A random signal generator according to one or more of claims 1 to 5 **characterised in that** the A/D converter circuit (IC1) is a negating Schmitt trigger logic circuit or a Schmitt trigger logic circuit with downstream-connected negator.

7. A random signal generator according to one or more of claims 1 to 6 **characterised in that** the Z-diodes have an operating range of 9 to 11 V.

8. A random signal generator according to claim 7 **characterised in that** the Z-diodes have an operating range of 9.5 to 10.5 V.

## Revendications

1. Générateur de signaux aléatoires (19) présentant:
(a) deux diodes de Zener (D1, D2) tenant lieu de source de bruit thermique et mettant chacune un signal de bruit à disposition,
(b) un amplificateur différenciateur (OV1) raccordé côté entrée aux deux diodes de Zener (D1, D2), qui élimine les signaux parasites périodiques,
(c) un circuit de conversion analogique-numérique (IC1) sur lequel est branché le signal différence de bruit, ledit circuit mettant à disposition à sa sortie un signal aléatoire numérique constitué de bits aléatoires successifs,
**caractérisé en ce que**
(d) l'amplificateur différenciateur permet une stabilisation du point de fonctionnement aux deux entrées dudit amplificateur différenciateur par l'intermédiaire d'une rétroaction exercée sur le signal différence de bruit, et
(e) **en ce que** le circuit de conversion analogique-numérique permet une stabilisation du point de fonctionnement à l'entrée dudit circuit de conversion analogique-numérique par l'intermédiaire d'une rétroaction exercée sur le signal aléatoire numérique.

2. Générateur de signaux aléatoires selon la revendication 1, **caractérisé en ce que** le signal aléatoire numérique est dirigé côté entrée vers un circuit numérique de reprise (IC2) comprenant un micro combinateur présentant un enchaînement OU exclusif de bits aléatoires successifs.

3. Générateur de signaux aléatoires selon la revendication 2, **caractérisé en ce que** la grille OU exclusive est conçue de manière à ce que 3 bits aléatoires successifs soient enchaînés entre eux.

4. Générateur de signaux aléatoires selon la revendication 2, **caractérisé en ce que** le circuit numérique de reprise (IC2) est conçu de manière à ce qu'une fréquence d'échantillonnage du signal aléatoire entrant soit réglée entre 1/8 et 1/12, de préférence 1/10, d'une fréquence moyenne du signal aléatoire.

5. Générateur de signaux aléatoires selon l'une quelconque des revendications 1 à 4, **caractérisé en ce que** le circuit de rétroaction du signal (12, 14) assurant la stabilisation du point de fonctionnement, est un filtre passe-bas.

6. Générateur de signaux aléatoires selon l'une ou plusieurs des revendications 1 à 5, **caractérisé en ce que** le circuit de conversion analogique-numérique (IC1) est un circuit virtuel NON du type bascule de Schmitt, ou encore un circuit virtuel du type bascule de Schmitt suivi d'un élément NON.

7. Générateur de signaux aléatoires selon l'une ou plusieurs des revendications 1 à 6, **caractérisé en ce que** la plage d'opération des diodes de Zener s'étend de 9 à 11 V.

8. Générateur de signaux aléatoires selon la revendication 7, **caractérise en ce que** la plage d'opération des diodes de Zener s'étend de 9,5 à 10,5 V.
